# EUROPÄISCHE PATENTANMELDUNG

(11) **EP 2 388 813 A2**
(43) Veröffentlichungstag der Anmeldung: **23.11.2011**
(21) Anmeldenummer: 11162025.8
(22) Anmeldetag: 12.04.2011
(51) Int. Cl.: H01L 23/373, H05K 3/24, H05K 3/38

(54) **Verfahren zur Herstellung von Leistungshalbleitersubstraten**

(30) Priorität: 18.05.2010 DE 102010020900
(71) Anmelder: SEMIKRON Elektronik GmbH & Co. KG, 90431 Nürnberg (DE)
(72) Erfinder: Göbl, Christian, 90441, Nürnberg (DE)

(57) **Zusammenfassung**

Es wird ein Verfahren zur Herstellung von Leistungshalbleitersubstraten (12) mit einem isolierenden flächigen Grundkörper (14) beschrieben, der an mindestens einer Hauptfläche (16) eine Schichtenfolge aus einer Sintermetallschicht (18) und einer Leitungsschicht (20) aufweist, durch Druck- und Temperaturbeaufschlagung, wobei das mindestens ein Leistungshalbleitersubstrat (12) mit einem Vergussmaterial (28) umschlossen wird und das mindestens eine mit dem Vergussmaterial (28) umschlossenes Leistungshalbleitersubstrat (12) anschließend in eine mit einer Flüssigkeit (30) gefüllte Druckkammer (10) eingebracht und mit Druck und Temperatur beaufschlagt wird, wobei der Druck an dem mindestens einen Leistungshalbleitersubstrat (12) unverzüglich isostatisch und die Temperatur an dem mindestens einen Leistungshalbleitersubstrat (12) zur stoffschlüssigen Verbindung des Grundkörpers (12) mittels der Sintermetallschicht (18) mit der zugehörigen Leitungsschicht (20) durch das eine definierte Wanddicke besitzende Vergussmaterial (28) zeitlich verzögert wirksam wird.

## Beschreibung

Die Erfindung betrifft ein Verfahren zur Herstellung von Leistungshalbleitersubstraten mit einem isolierenden flächigen Grundkörper, der an mindestens einer Hauptfläche eine Schichtenfolge aus einer Sintermetallschicht und einer Leitungsschicht aufweist, durch Druck- und Temperaturbeaufschlagung.

Ein derartiges Verfahren ist aus der DE 10 2007 022 337 A1 der Anmelderin bekannt. Bei diesem bekannten Verfahren folgt die Druckbeaufschlagung mittels einer Presse, die zwei Pressstempel aufweist, wobei mindestens ein Pressstempel mit einem Silikonkissen ausgebildet ist, um einen quasi isostatischen Druck zu erzeugen. Während der Druckbeaufschlagung wird das Leistungshalbleitersubstrat auf eine Temperatur zwischen 350 K und 600 K erwärmt.

Mit diesem bekannten Verfahren sind lediglich quasi isostatische Drücke aufbaubar, was sich auf die stoffschlüssige Verbindung der mindestens eine Leitungsschicht an dem isolierenden flächigen Grundkörper auswirkt.

Der Erfindung liegt die Aufgabe zugrunde, das Verfahren der eingangs genannten Art derartig weiterzubilden, dass nicht nur ein quasi isostatischer Druck sondern ein isostatischer Druck und somit eine zuverlässige stoffschlüssige Verbindung des isolierenden flächigen Grundkörpers mit der mindestens einen Leitungsschicht realisiert wird.

Diese Aufgabe wird erfindungsgemäß durch die Merkmale des Anspruches 1 d. h. dadurch gelöst, dass mindestens ein Leistungshalbleitersubstrat mit einem Vergussmaterial umschlossen wird, und dass das mindestens eine, mit dem Vergussmaterial umschlossene Leistungshalbleitersubstrat anschließend in eine mit einer Flüssigkeit gefüllte Druckkammer eingebracht und mit Druck und Temperatur beaufschlagt wird, wobei der Druck an dem mindestens einen Leistungshalbleitersubstrat unverzüglich isostatisch und die Temperatur an dem mindestens einen Leistungshalbleitersubstrat zur stoffschlüssigen Verbindung des isolierenden flächigen Grundkörpers mittels der Sintermetallschicht mit der zugehörigen Leistungsschicht durch das Vergussmaterial zeitlich verzögert wirksam wird.

Das erfindungsgemäße Verfahren weist den Vorteil auf, dass die zeitliche Verzögerung der Temperaturwirkung in Abhängigkeit von der Dicke des Vergussmaterials wunschgemäß einstellbar ist, so dass die Druckkammer nicht sofort verschlossen zu werden braucht, sondern wunschgemäß auch erst zu einem späteren Zeitpunkt geschlossen werden kann, weil die Temperatur der in der Druckkammer befindlichen Flüssigkeit durch das Vergussmaterial erst zeitlich verzögert bei dem mindestens einen Leistungshalbleitersubstrat ankommt.

Als Vergussmaterial wird bei dem erfindungsgemäßen Verfahren vorzugsweise ein Silikonvergussmaterial verwendet. Für die Sintermetallschicht wird vorzugsweise eine Sinterpaste verwendet. Bei der Sinterpaste handelt es sich in bekannter Weise um ein geeignetes Sintermetall in Kombination mit einem Lösungsmittel. Das Sintermetall kann beispielsweise Metallflocken mit Ausdehnungen in der Größenordnung einiger µm aufweisen.

Bei der Flüssigkeit in der Druckkammer handelt es sich zweckmäßigerweise um ein geeignetes Öl. Die Flüssigkeit in der Druckkammer wird vorzugsweise auf eine Temperatur von 220 °C bis 280 °C, vorzugsweise 250 °C, erwärmt und mit einem Druck von 35 MPa bis 45 MPa, vorzugsweise 38 MPa bis 40 MPa, beaufschlagt.

Um mit dem erfindungsgemäßen Verfahren eine ausgezeichnete Produktivität zu erzielen, d. h. eine vergleichsweise große Anzahl Leistungshalbleitersubstrate pro Zeiteinheit zu verwirklichen, wird erfindungsgemäß vorgeschlagen, dass eine Anzahl Leistungshalbleitersubstrate zu einem Stapel übereinander angeordnet werden, der mit dem Vergussmaterial umschlossen und danach in die mit der Flüssigkeit gefüllte Druckkammer eingebracht wird. Hierfür wird ein selbstständiger Patentschutz beantragt. Bei diesem erfindungsgemäßen Verfahren wird der Stapel vorzugsweise aus einer wiederkehrenden Lagenfolge gebildet, die jeweils aus einer Silikonfolie, einer eine Leitungsschicht bildenden Metallfolie, einer Sinterpaste, einem isolierenden flächigen Grundkörper, einer Sinterpaste, einer eine Leitungsschicht bildenden Metallfolie und einer Silikonfolie besteht.

Das erfindungsgemäße Verfahren eignet sich beispielsweise zur Herstellung von Leistungshalbleitersubstraten der Abmessungen 5" x 7", wobei selbstverständlich auch Leistungshalbleitersubstrate mit anderen Abmessungen realisierbar sind.

Als vorteilhaft hat es sich erwiesen, wenn der besagte Stapel mit einer wärmestabilen Folie umgeben wird, wonach die Umhüllung mit dem Vergussmaterial erfolgt.

Das erfindungsgemäße Verfahren weist die Vorteile auf, dass der Druck in den Stapel isostatisch eingeleitet und an den Leistungshalbleitersubstraten isostatisch wirksam wird, dass durch das Vergussmaterial die Dichtheit zur Flüssigkeit in der Druckkammer gewährleistet wird, und dass die Vergussmasse eine thermische Isolierung für den Verfahrensablauf beim Sintern darstellt. Das Vergussmaterial besitzt beispielsweise eine Wärmeleitfähigkeit von 0,3 W/m.K. Die wärmestabile Folie, mit welcher der Stapel umgeben wird, bevor der Stapel mit dem Vergussmaterial umhüllt wird, kann beispielsweise von einer Aluminiumfolie gebildet sein.

Weitere Einzelheiten, Merkmale und Vorteile ergeben sich aus der nachfolgenden Beschreibung in Verbindung mit der anliegenden Zeichnung.

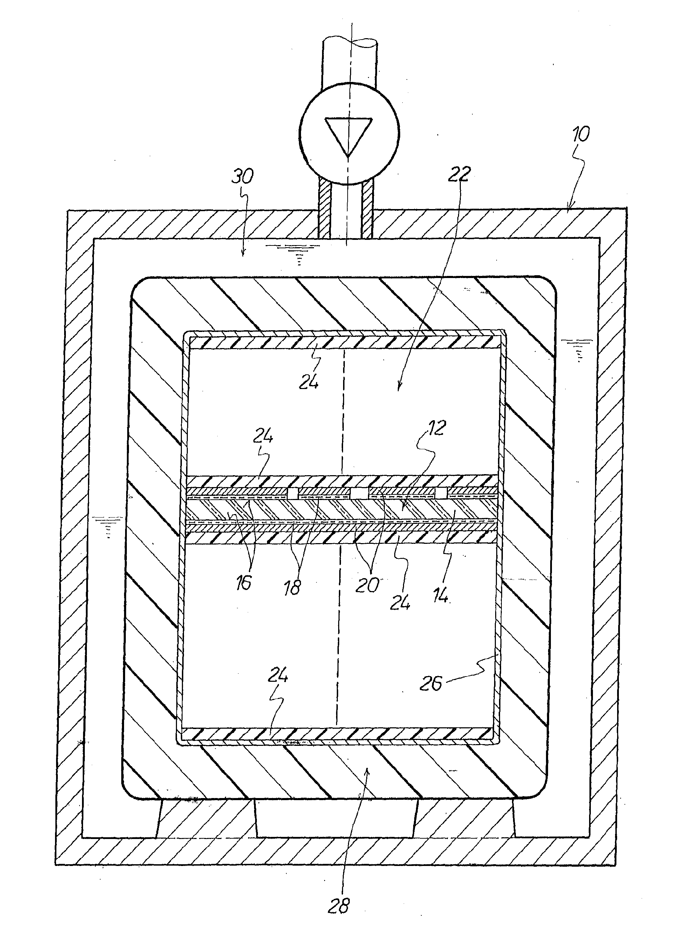

Die Figur verdeutlicht schematisch eine Druckkammer 10, in der eine Anzahl Leistungshalbleitersubstrate 12 zu einem Stapel übereinander gestapelt sind, wobei in der Zeichnungsfigur nur ein Leistungshalbleitersubstrat 12 gezeichnet ist. Das jeweilige Leistungshalbleitersubstrat 12 weist einen isolierenden flächigen Grundkörper 14 auf, der an seinen beiden voneinander abgewandten Hauptflächen 16 jeweils eine Schichtenfolge aus einer Sintermetallschicht 18 und einer Leitungsschicht 20 aufweist. Die Leitungsschicht 20 kann großflächig und/oder schaltstrukturiert ausgebildet sein.

Der nur schematisch verdeutlichte Stapel 22 mit einer Anzahl solcher Leistungshalbleitersubstrate 12 ist aus einer wiederkehrenden Lagenfolge gebildet, die aus einer Silikonfolie 24, einer eine Leitungsschicht (20) bildenden Metallfolie, einer eine Sintermetallschicht (18) bildenden Sinterpaste, einem isolierenden flächigen Grundkörper 14, einer von einer Sinterpaste gebildeten Sintermetallschicht 18, einer eine Leitungsschicht 20 bildenden Metallfolie und einer Silikonfolie 24 besteht. Der solchermaßen ausgebildete Stapel 22 ist mit einer wärmestabilen Folie 26 umgeben, die beispielsweise von einer Aluminiumfolie gebildet ist. Der mit der wärmestabilen Folie 26 umgebene Stapel 22 ist mit einem Vergussmaterial 28 umschlossen, bei dem es sich vorzugsweise um ein Silikonvergussmaterial handelt.

Das vom Vergussmaterial 28 umschlossene Stapel-Gebilde ist in der mit einer Flüssigkeit 30 gefüllten Druckkammer 10 angeordnet und wird isostatisch mit Druck und Temperatur beaufschlagt, wobei der Druck am Stapel 22 mit den übereinander gestapelten Leistungshalbleitersubstraten 12 unverzüglich isostatisch und die Temperatur an den Leistungshalbleitersubstraten 12 durch das Vergussmaterial 28 zeitlich verzögert wirksam wird, um eine stoffschlüssige Verbindung des jeweiligen Grundkörpers 14 mittels der Sintermetallschicht 18 mit der zugehörigen Leitungsschicht 20 zu bewirken. Nach der stoffschlüssigen Verbindung wird die Druckkammer 10 geöffnet und das Vergussmaterial 28 und die wärmestabile Folie 26 vom Stapel 22 entfernt, wonach die einzelnen Leistungshalbleitersubstrate 12 mit den an ihnen stoffschlüssig vorgesehenen Leitungsschichten 20 einzeln zur Verfügung stehen, weil die Silikonfolien 24 eine problemlose Trennung der einzelnen Leistungshalbleitersubstrate 12 voneinander ermöglichen.

### Bezuasziffernliste:

- 10: Druckkammer (für 12)
- 12: Leistungshalbleitersubstrat
- 14: Grundkörper (von 12)
- 16: Hauptfläche (von 14)
- 18: Sintermetallschicht (an 16)
- 20: Leitungsschicht (an 18)
- 22: Stapel (von 12)
- 24: Silikonfolie (zwischen 12 und 12)
- 26: wärmestabile Folie (an 22)
- 28: Vergussmaterial (für 22)
- 30: Flüssigkeit (in 10)

## Patentansprüche

1. Verfahren zur Herstellung von Leistungshalbleitersubstraten (12) mit einem isolierenden flächigen Grundkörper (14), der an mindestens einer Hauptfläche (16) eine Schichtenfolge aus einer Sintermetallschicht (18) und einer Leitungsschicht (20) aufweist, durch Druck- und Temperaturbeaufschlagung,
**dadurch gekennzeichnet,**
**dass** mindestens ein Leistungshalbleitersubstrat (12) mit einem Vergussmaterial (28) umschlossen wird, und dass das mindestens eine mit dem Vergussmaterial (28) umschlossene Leistungshalbleitersubstrat (12) anschließend in eine mit einer Flüssigkeit (30) gefüllte Druckkammer (10) eingebracht und mit Druck und Temperatur beaufschlagt wird, wobei der Druck an dem mindestens einen Leistungshalbleitersubstrat (12) unverzüglich isostatisch und die Temperatur an dem mindestens einen Leistungshalbleitersubstrat (12) zur stoffschlüssigen Verbindung des Grundkörpers (12) mittels der Sintermetallschicht (18) mit der zugehörigen Leitungsschicht (20) durch das Vergussmaterial (28) zeitlich verzögert wirksam wird.

2. Verfahren nach Anspruch 1,
**dadurch gekennzeichnet,**
**dass** als Vergussmaterial (28) ein Silikonvergussmaterial verwendet wird.

3. Verfahren nach Anspruch 1,
**dadurch gekennzeichnet,**
**dass** für die Sintermetallschicht (18) eine Sinterpaste verwendet wird.

4. Verfahren nach Anspruch 1,
**dadurch gekennzeichnet,**
**dass** die Flüssigkeit (30) in der Druckkammer (10) auf eine Temperatur von 220 °C bis 280 °C, vorzugsweise 250 °C, erwärmt und mit einem Druck von 35 MPa bis 45 MPa, vorzugsweise 38 MPa bis 40 MPa, beaufschlagt wird.

5. Verfahren insbesondere nach einem der vorhergehenden Ansprüche,
**dadurch gekennzeichnet,**
**dass** eine Anzahl Leistungshalbleitersubstrate (12) zu einem Stapel (12) übereinander angeordnet werden, der mit dem Vergussmaterial (28) umschlossen wird.

6. Verfahren nach Anspruch 5,
**dadurch gekennzeichnet,**
**dass** der Stapel (22) aus einer wiederkehrenden Lagenfolie gebildet wird, die aus einer Silikonfolie (24), einer eine Leitungsschicht (20) bildenden Metallfolie, einer eine Sintermetallschicht (18) bildenden Sinterpaste, einem isolierenden flächigen Grundkörper (14), einer eine Sintermetallschicht (18) bildenden Sinterpaste, eine eine Leitungsschicht (20) bildenden Metallfolie und einer Silikonfolie (24) besteht.

7. Verfahren nach Anspruch 5 oder 6,
**dadurch gekennzeichnet,**
**dass** der Stapel (22) mit einer wärmestabilen Folie (26) umgeben wird, wonach die Umhüllung mit dem Vergussmaterial (28) erfolgt.
